Europäisches Patentamt

European Patent Office

Office européen des brevets

(19)

(11) **EP 0 901 223 A2**

(12) **EUROPÄISCHE PATENTANMELDUNG**

(43) Veröffentlichungstag:
      **10.03.1999 Patentblatt 1999/10**

(51) Int. Cl.$^6$: **H03G 3/30**

(21) Anmeldenummer: **98116019.5**

(22) Anmeldetag: **25.08.1998**

(84) Benannte Vertragsstaaten:
      **AT BE CH CY DE DK ES FI FR GB GR IE IT LI LU
      MC NL PT SE**
      Benannte Erstreckungsstaaten:
      **AL LT LV MK RO SI**

(30) Priorität: **02.09.1997 DE 19738363**

(71) Anmelder:
      **SIEMENS AKTIENGESELLSCHAFT
      80333 München (DE)**

(72) Erfinder: **Heinen, Stefan
      47802 Krefeld (DE)**

(54) **Empfänger für Mobilfunksysteme**

(57)     Empfänger für Mobilfunksysteme in Form eines Low-IF- oder Zero-IF-Empfängers zur Verarbeitung einer Inphase- (I) und einer Quadraturkomponente (Q) eines Empfangssignals mit einem Filter (10) und einem automatischen Schwundausgleich (12) wobei dem automatischen Schwundausgleich (12) eine analoge Demodulatorstufe (14) nachgeschaltet ist. In der analogen Demodulatorstufe (14) wird sowohl die Inphasekomponente (I) als auch die Quadraturkomponente (Q) jeweils einem Differenzierer (16, 20) zugeführt, und das Ausgangssignal des Differenzierers (16) für die Inphasekomponente mit der Quadraturkomponente und das Ausgangssignal des Differenzierers (20) für die Quadraturkomponente mit der Inphasekomponente multipliziert und die beiden Produkte verknüpft. Dabei wird das Produkt aus differenzierter Inphasekomponente und Quadraturkomponente von dem Produkt aus differenzierter Quadraturkomponente und Inphasekomponente subtrahiert.

Fig. 1

EP 0 901 223 A2

**Beschreibung**

Die vorliegende Erfindung betrifft einen Empfänger für Mobilfunksysteme in Form eines Low-IF- oder Zero-IF-Empfängers zur Verarbeitung einer Inphase- und Quadraturkomponente eines Empfangssignals mit einem Filter und einem automatischen Schwundausgleich.

Die vollständige Integration eines Empfängers für Mobilfunksysteme kann durch Realisierung eines Low-IF- oder Zero-IF-Empfängers gelöst werden. Low-IF bedeutet in diesem Zusammenhang, daß die Zwischenfrequenz in der Größenordnung der Modulationsfrequenz liegt, Zero-IF bedeutet, daß keine Zwischenfrequenz verwendet wird.

In der Druckschrift US 5,483,691 ist ein Zero-IF-Empfänger beschrieben, bei dem eine AGC-Schaltung (Automatic Gain Controll) vorgesehen ist. Deren Aufgabe besteht in der Reduktion der Signalverzerrung bei hohen Eingangssignalbedingungen. Die derart verstärkte Inphasekomponente und die derart verstärkte Quadraturkomponente werden unter Verwendung jeweils eines Mischerz mit einem lokalen Oszillatorsignal heruntergemischt und anschließend addiert.

Aus der Druckschrift DE 3 516 492 A1 ist ebenfalls ein Zero-IF-Empfänger bekannt. Zur Unterdrückung von Störsignalen enthält er einen Rückkopplungskreis. Die Trennung der im Empfangssignal enthaltenen Störsignale vom Nutzsignal erfolgt durch Filter im Basisband. Die Störsignale werden danach wieder in die Hochfrequenzlage umgesetzt und nach Verstärkung durch einen Subtrahierer vom Empfangssignal subtrahiert. Im eingeschwungenen Zustand tritt am Ausgang des Subtrahierers das Nutzsignal auf, da es im Basisband umgesetzt und dann einer Signalverarbeitungseinrichtung zugeführt ist.

Aus der WO 96/08849 ist schließlich ein Funkübertragungssystem mit mehreren Front-and-Empfängern bekannt. Die Ausgangssignalkomponenten eines Front-and-Empfängers, in Form von Inphase- und Quadraturkomponenten werden Phasenschiebern zugeführt, um anschließend mit den Inphase- und Quadraturkomponenten eines weiteren Front-and-Empfängers additiv verknüpft zu werden.

Dabei ist die Demodulation eines GFSK-modulierten Signals eines der wesentlichen Probleme.

Gemäß dem Stand der Technik wurde dieses Problem durch eine Analog/Digital-Wandlung des Signals nach dem automatischen Schwundausgleich mit anschließender digitaler Signalverarbeitung gelöst. Aufgrund der komplexen digitalen Signalverarbeitung waren solche Schaltungen gemäß dem Stand der Technik sehr aufwendig.

Es ist daher Aufgabe der Erfindung, einen Empfänger für Mobilfunksysteme zu schaffen, bei dem die Demodulation des GFSK-modulierten Signals erheblich einfacher gelöst ist.

Erfindungsgemäß wird diese Aufgabe dadurch gelöst, daß dem automatischen Schwundausgleich (AGC) eine analoge Demodulatorstufe nachgeschaltet ist.

Vorzugsweise erfolgt die analoge Demodulation dadurch, daß sowohl die Inphasekomponente als auch die Quadraturkomponente jeweils einem Differenzierer zugeführt werden, und das Ausgangssignal des Differenzierers für die Inphasekomponente mit der Quadraturkomponente und das Ausgangssignal des Differenzierers für die Quadraturkomponente mit der Inphasekomponente multipliziert wird, und die beiden Produkte verknüpft werden.

Dabei ist es besonders bevorzugt, daß das Produkt aus differenzierter Inphasekomponente und Quadraturkomponente von dem Produkt aus differenzierter Quadraturkomponente und Inphasekomponente subtrahiert wird. Auf diese Weise entsteht ein vorzeichenrichtiges demoduliertes Signal. Sofern die Elemente der Subtraktion vertauscht werden, kann ein umgekehrtes (negatives) demoduliertes Signal erhalten werden, sofern dies bei der Weiterverarbeitung gewünscht werden sollte.

Die vorliegende Erfindung wird im folgenden anhand des in der Zeichnung dargestellten Ausführungsbeispiels näher erläutert. Es zeigt:

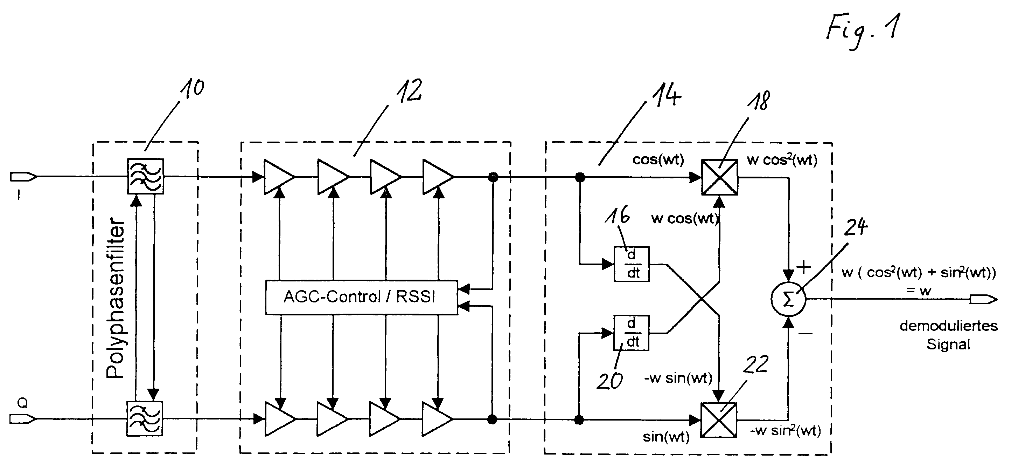

Figur 1 ein Blockschaltbild eines erfindungsgemäßen Empfängers für Mobilfunksysteme.

Fig. 1 zeigt in einem Blockschaltbild die für die vorliegende Erfindung bedeutsamen Teile eines Empfängers für Mobilfunksysteme. Auch bei dem Empfänger gemäß der vorliegenden Erfindung werden die Inphase- und Quadraturkomponenten des Empfangssignals in üblicher Weise erzeugt. Das Blockschaltbild beginnt daher mit den Eingängen für die Inphasekomponente (I) und die Quadraturkomponente (Q). Diese Eingänge führen bei Verwendung der vorliegenden Erfindung in einem Low-IF-System zu einem Polyphasenfilter 10, das einer entsprechenden Kanalfilterung dient. Im Falle eines Zero-IF-Systems ist hier ein Tiefpassfilter einzusetzen.

Vom Polyphasenfilter 10 oder dem entsprechenden Tiefpassfilter wird die Inphasekomponente und die Quadraturkomponente einer AGC-Stufe 12 zugeführt. Es handelt sich dabei um eine Verstärkerstufe mit automatischer Verstärkungsregelung, die dem automatischen Schwundausgleich dient. Dadurch ergibt sich am Ausgang dieser AGC-Stufe 12 ein nahezu konstanter Signalpegel.

Nach der AGC-Stufe 12 werden die Inphasekomponente und die Quadraturkomponente erfindungsgemäß einem analogen Demodulator 14 zugeführt.

Der analoge Demodulator 14 ist folgendermaßen aufgebaut: Die Inphasekomponente wird einem Differenzierer 16 und einem Multiplizierer 18 zugeführt. Ebenso wird die Quadraturkomponente (Q) einem weiteren Differenzierer 20 und einem weiteren Multiplizierer 22 zugeführt.

Gleichzeitig wird das Ausgangssignal des Differenzierers 16, also die differenzierte Inphasekomponente dem weiteren Multiplizierer 22 zugeführt, so daß am Ausgang dieses Multiplizierers das Produkt aus Quadraturkomponente und differenzierter Inphasekomponente vorliegt. Ebenso ist das Ausgangssignal des weiteren Differenzierers 20, also die differenzierte Quadraturkomponente mit dem Multiplizierer 18 verbunden, so daß an dessen Ausgang das Produkt aus Inphasekomponente und differenzierter Quadraturkomponente vorliegt. Die Ausgänge der beiden Multiplizierer 18, 22 werden einem Summierer 24 mit einem positiven und einem negativen (invertierenden) Eingang zugeführt.

Bei der vorliegenden Ausführungsform ist der Ausgang des Multiplizierers 18 mit dem positiven Eingang des Summierers 24 verbunden und der Ausgang des Multiplizierers 22 mit dem negativen Eingang des Summierers 24. Dadurch liegt am Ausgang des Summierers das demodulierte Signal w in positiver Form vor.

Sofern das negative demodulierte Signal gewünscht wird, können die Anschlüsse des Summierers 24 entsprechend vertauscht werden. Der Multiplizierer 22 ist dann mit dem positiven Eingang des Summierers 24 verbunden und der Multiplizierer 18 mit dem negativen Eingang des Summierers 24. Als demoduliertes Signal liegt dann ein invertiertes oder negatives demoduliertes Signal -w vor.

Die Funktion des analogen Demodulators läßt sich mathematisch folgendermaßen darstellen:

Die Inphasekomponente des empfangenen Signals liegt in der Form $\cos(wt)$ und die Quadraturkomponente in der Form $\sin(wt)$ vor. Durch die Differenziation in dem Differenzierer 16 entsteht aus der Inphasekomponente das Signal $-w \sin(wt)$ und durch den weiteren Differenzierer 20 entsteht aus der Quadraturkomponente das Signal $w \cos(wt)$. Im Multiplizierer 18 wird nun die Inphasekomponente $\cos(wt)$ mit der differenzierten Quadraturkomponente $w \cos(wt)$ multipliziert. Am Ausgang des Multiplizierers 18 liegt somit das Signal $w \cos^2(wt)$ vor.

Im Multiplizierer 22 wird gleichzeitig die Quadraturkomponente $\sin(wt)$ mit der differenzierten Inphasekomponente $-w \sin(wt)$ multipliziert, so daß am Ausgang des Multiplizierers 22 das Signal $-w \sin^2(wt)$ vorliegt. Durch den Summierer 24, an dessen negativem Eingang nun das Signal $-w \sin^2(wt)$ und an dessen positivem Eingang das Signal $w \cos^2(wt)$ anliegt, ergibt sich: $w \cos^2(wt)-(-w \sin^2(wt)) = w (\cos^2(wt) + \sin^2(wt)) = w$. Somit liegt am Ausgang ausschließlich das demodulierte Signal w vor. Es ergibt sich somit unter der Annahme, daß sich die Kreisfrequenz nur langsam ändert, ein Ausgangssignal, das direkt proportional der Modulationsfrequenz ist. Für ein Zero-IF-System (ohne Zwischenfrequenz) hat dieses Signal keinen Gleichanteil. Bei einem Low-IF-System entspricht der Gleichanteil der Zwischenfrequenz und kann, da die Zwischenfrequenz ja stets verfügbar ist, durch Subtraktion eliminiert werden.

Bezugszeichenliste

10 =   Polyphasenfilter
12 =   AGC-Stufe
14 =   Analoger Demodulator
16 =   Differenzierer (I)
18 =   Multiplizierer (I)
20 =   Weiterer Differenzierer (Q)
22 =   Weiterer Multiplizierer (Q)
24 =   Summierer

**Patentansprüche**

1.   Empfänger für Mobilfunksysteme in Form eines Low-IF- oder Zero-IF-Empfängers zur Verarbeitung einer Inphase- (I) und Quadraturkomponente (Q) eines Empfangssignals mit einem Filter (10) und einem automatischen Schwundausgleich (12), dadurch gekennzeichnet, daß dem automatischen Schwundausgleich (12) eine analoge Demodulatorstufe (14) nachgeschaltet ist, daß in der analogen Demodulatorstufe (14) sowohl die Inphasekomponente (I) als auch die Quadraturkomponente (Q) jeweils einem Differenzierer (16, 20) zugeführt werden, und das Ausgangssignal des Differenzierers (16) für die Inphasekomponente mit der Quadraturkomponente und das Ausgangssignal des Differenzierers (20) für die Quadraturkomponente mit der Inphasekomponente multipliziert wird, und die beiden Produkte verknüpft werden.

2.   Empfänger nach Anspruch 1,
**dadurch gekennzeichnet,** daß
das Produkt aus differenzierter Inphasekomponente und Quadraturkomponente von dem Produkt aus differenzierter Quadraturkomponente und Inphasekomponente subtrahiert wird.

Fig. 1

EP 0 901 223 A2